# FASCICULE DE BREVET EUROPEEN

(11) **EP 0 456 061 B1**
(45) Date de publication et mention de la délivrance du brevet: **01.03.1995**
(21) Numéro de dépôt: 91106865.8
(22) Date de dépôt: 27.04.1991
(51) Int. Cl.: H03H 9/05, H03H 9/17

(54) **Résonateur comportant un barreau destiné à vibrer dans un mode d'allongement**
Resonator mit einer longitudinal schwingenden Stange
Resonator having a bar for oscillating in a longitudinal mode

(30) Priorité: 10.05.1990 FR 9005971
(43) Date de publication de la demande: 13.11.1991
(73) Titulaire: Eta SA Fabriques d'Ebauches, 2540 Granges (CH)
(72) Inventeur: Zingg, Walter, CH-2520 La Neuveville (CH); Studer, Bruno, CH-4533 Riedholz (CH)
(74) Mandataire: de Montmollin, Henri

(56) Documents cités:
- EP-A- 0 056 783
- DE-A- 2 534 683
- US-A- 1 954 238
- US-A- 3 906 260

## Description

La présente invention a pour objet un résonateur comportant un barreau parallélépipédique en un matériau piézoélectrique destiné à vibrer dans un mode d'allongement et des moyens de suspension dudit barreau formant une seule et même pièce avec ledit barreau, et destinés à relier ledit barreau à une base.

De tels résonateurs sont décrits, notamment, dans les brevets GB-B-1 560 537 et US-A-4 608 510 et ne seront donc pas décrits à nouveau en détail ici.

On relèvera simplement que tous ces résonateurs connus comportent des moyens de suspension de leur barreau comprenant deux bras perpendiculaires à l'axe longitudinal du barreau, symétriques l'un de l'autre par rapport à cet axe, et ayant chacun une extrémité reliée à l'une des faces latérales de ce barreau, sensiblement au milieu de sa longueur.

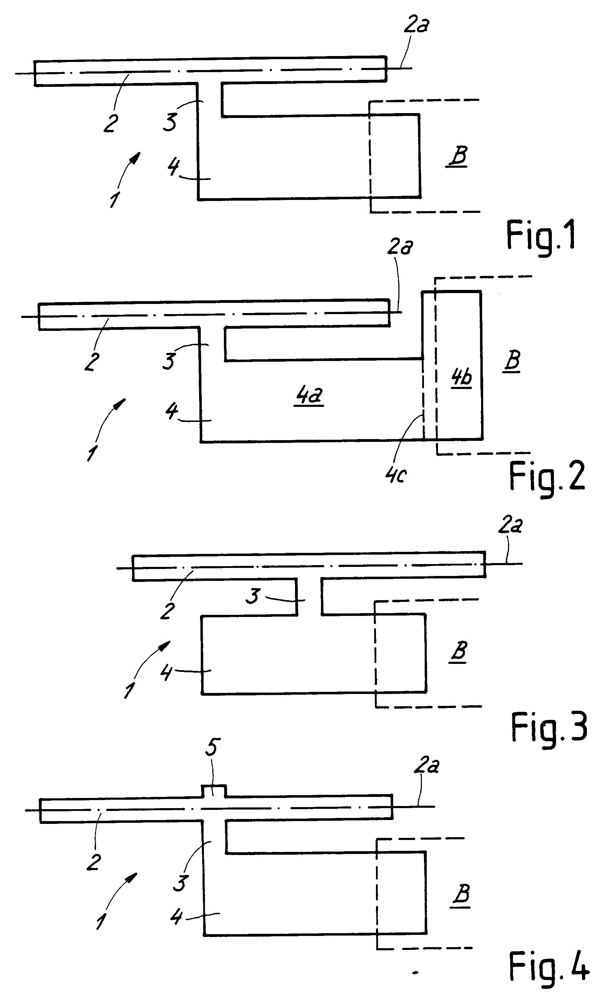

Ces moyens de suspension comportent en outre des supports parallèles à l'axe longitudinal du barreau, également symétriques par rapport à cet axe, et reliés à l'autre extrémité des bras mentionnés ci-dessus. Ces supports forment, avec des pièces complémentaires, un cadre entourant complètement le barreau, comme dans la figure 1 du brevet GB-B-1 560 537 déjà mentionné, ou seulement une moitié de celui-ci, comme dans la figure 5 du même brevet GB ou dans la figure 4 du brevet US-A-4 608 510 également déjà mentionné.

Les bornes de connexion électrique du résonateur, qui servent également à le fixer mécaniquement sur une base, sont disposées sur ce cadre, et les pistes conductrices reliant ces bornes aux électrodes d'excitation de la vibration du barreau sont également disposées, en partie, sur ce cadre, et se prolongent sur les bras mentionnés ci-dessus.

Un résonateur de ce genre présente généralement de bonnes caractéristiques, notamment un facteur de qualité élevé. Il est en outre assez facile à fabriquer en grandes séries, notamment par les procédés bien connus utilisant des techniques de photolithographie et de découpage chimique, surtout lorsqu'il est semblable au résonateur décrit dans le brevet US-A-4 608 510. Son prix de revient est donc assez faible.

Cependant, un tel résonateur, comme tous les résonateurs, de quelque genre qu'ils soient, est un système vibrant très complexe.

Chacun de ses composants, et notamment chacun des éléments des moyens de suspension de son barreau, peut en effet être mis en vibration dans un grand nombre de modes différents qui, à l'exception du mode principal d'allongement dans lequel la vibration du barreau est excitée, sont tous des modes parasites.

Ces modes parasites ont des fréquences et des amplitudes qui ne peuvent pratiquement pas être connues à l'avance car elles dépendent des dimensions exactes des divers composants du résonateur, notamment des moyens de suspension de son barreau. Or ces dimensions présentent toujours de petites différences d'un résonateur à l'autre, même à l'intérieur d'un même lot de fabrication. On a également constaté que ces fréquences et ces amplitudes dépendent assez fortement de la manière dont le résonateur est fixé sur sa base ainsi que de l'amplitude du signal d'excitation qui lui est appliqué par le circuit oscillateur auquel il est relié. En outre, ces fréquences et ces amplitudes varient en fonction de la température, de manière différente d'un mode à l'autre.

Or, lorsque la fréquence de l'un de ces modes parasites est proche de la fréquence du mode principal de vibration du barreau ou de l'un de ses harmoniques, ce mode parasite peut se coupler à ce mode principal et, si son amplitude est assez grande, il peut absorber une partie non-négligeable de l'énergie du mode principal. Un tel couplage peut avoir pour effet de modifier la fréquence de vibration du résonateur et/ou de dégrader ses caractéristiques, notamment son facteur de qualité, dégradation qui peut même entraîner l'arrêt du circuit oscillateur dont fait partie ce résonateur.

Dans les résonateurs connus décrits ci-dessus, le risque d'un tel couplage est particulièrement grand. En effet, les variations de la longueur du barreau lorsque celui-ci vibre dans son mode principal de vibration sont obligatoirement accompagnées de variations de sa largeur. En d'autres termes, le barreau vibre simultanément dans son mode principal d'allongement et dans un mode secondaire transversal, ces deux modes étant parfaitement couplés et ayant exactement la même fréquence.

Les moyens de suspension du barreau étant rigidement reliés aux faces latérales de celui-ci qui sont déplacées par cette vibration transversale, cette dernière peut évidemment très facilement se coupler avec l'une ou l'autre des vibrations parasites qui peuvent prendre naissance dans ces moyens de suspension, notamment dans les supports parallèles à la longueur du barreau.

Il résulte de ce qui précède que tous ces résonateurs connus ont des caractéristiques, et des variations de celles-ci en fonction de la température, qui ne sont pas complètement prévisibles. Ces résonateurs doivent donc être tous essayés, à la fin de leur fabrication, dans toute la gamme de température dans laquelle ils doivent fonctionner car, même dans un seul et même lot de fabrication, certains d'entre eux peuvent présenter, à certaines températures, une variation de leur fréquence de vibration et/ou une diminution de leur facteur de qualité qui dépassent les tolérances admises. Ces derniers résonateurs doivent évidemment être éliminés. Le coût de ces essais et la diminution du rendement de fabrication causée par cette élimination des résonateurs défectueux augmentent évidemment le prix de revient de ces résonateurs.

En outre, avant de lancer la fabrication en série d'un nouveau résonateur, et même si celui-ci ne diffère que peu d'un résonateur déjà fabriqué, il faut pratiquer de nombreux essais sur ce nouveau résonateur pour vérifier ses caractéristiques. Très souvent, ces essais montrent que ces caractéristiques ne sont pas exactement celles qui sont désirées. Il faut alors modifier la forme et/ou les dimensions de l'un ou l'autre des composants de ce nouveau résonateur, et refaire ensuite des essais pour déterminer si ces modifications ont bien eu l'effet escompté. Ce processus doit parfois être répété à plusieurs reprises.

Ces essais et ces modifications sont évidemment longs et coûteux et augmentent encore le prix de revient de ces résonateurs connus.

Le brevet US-A-3 906 260 décrit un résonateur comportant un barreau destiné à vibrer en torsion autour de son axe longitudinal et un bras unique de suspension de ce barreau qui ne forme qu'une seule et même pièce avec ce dernier. Une des extrémités de ce bras est reliée à l'une des faces du barreau, au milieu de la longueur de ce barreau, et l'autre extrémité de ce bras, qui porte les bornes de contact électrique du résonateur, est fixée par soudage directement sur des fils de connexion qui traversent une base faisant partie du boîtier du résonateur.

L'expérience a montré qu'un résonateur comprenant un barreau destiné à vibrer en allongement et un bras unique semblable à celui du résonateur décrit dans ce brevet US-A-3 906 260 présente à peu près les mêmes inconvénients que les résonateurs décrits précédemment. Ceci est dû au fait que la soudure des bornes de contact du résonateur sur les fils traversant la base ne peut pas présenter rigoureusement les mêmes caractéristiques d'un exemplaire à l'autre, et que cette base elle-même peut être le siège de vibrations parasites ayant des fréquences qui ne sont pas prévisibles, pas plus que leur variation en fonction de la température. De plus, les fréquences de ces vibrations parasites dépendent de la manière dont le résonateur encapsulé est monté à son emplacement définitif.

Un but de la présente invention est de proposer un résonateur du genre défini ci-dessus qui ne présente pas les inconvénients des résonateurs connus, c'est-à-dire un résonateur dont les caractéristiques et leur variation en fonction de la température sont mieux prévisibles, plus constantes d'un exemplaire à l'autre, et plus indépendantes de la manière dont il est monté sur sa base et de l'amplitude du signal d'excitation qui lui est appliqué. Grâce à ces propriétés, les essais qu'il doit subir à la fin de sa fabrication et/ou ceux qui doivent être faits avant de lancer sa fabrication lorsqu'il a été modifié sont simplifiés, le rendement de sa fabrication est augmenté, et son prix de revient est donc diminué.

Ce but est atteint par le résonateur revendiqué.

D'autres caractéristiques et avantages du résonateur selon l'invention apparaîtront dans la description qui va être faite maintenant à l'aide du dessin annexé.

Dans ce dessin, les figures 1 à 4 représentent chacune, à titre d'exemple non limitatif, une forme d'exécution du résonateur selon l'invention dans une vue en plan schématique.

Dans toutes ces figures, les résonateurs et leurs composants semblables sont désignés par les mêmes références.

Le résonateur représenté à titre d'exemple non limitatif à la figure 1 avec la référence 1 comporte un barreau parallélépipédique allongé 2 destiné à vibrer dans un mode d'allongement, qui est aussi parfois appelé mode d'extension-contraction.

Les dimensions de ce barreau 2, notamment sa longueur, sont déterminées, comme dans les résonateurs connus, en fonction de la fréquence à laquelle il doit vibrer et des contraintes technologiques imposées par le procédé choisi pour la fabrication du résonateur 1.

Les moyens de suspension du barreau 2 comportent un bras unique 3 dont une première extrémité est reliée à l'une des faces latérales du barreau 2 sensiblement au milieu de sa longueur et perpendiculairement à son axe longitudinal 2a. Les dimensions de ce bras 3 ne sont pas critiques et sont essentiellement déterminées par les contraintes technologiques mentionnées ci-dessus.

Les moyens de suspension du barreau 2 comportent en outre un support 4 ayant, dans cet exemple, la forme générale d'un rectangle dont la longueur est parallèle à l'axe longitudinal 2a du barreau 2.

Le bras 3 est relié à une des extrémités du support 4, perpendiculairement à l'un des grands côtés de celui-ci.

L'autre extrémité du support 4 est destinée à être fixée, par exemple par collage, à une base faisant partie d'un boîtier de protection du résonateur 1. Cette base n'a été représentée que très schématiquement par un trait interrompu, avec la référence B, et ce boîtier n'a pas été du tout représenté, car il s'agit d'éléments bien connus des spécialistes et dont la nature exacte n'a pas de rapport direct avec la présente invention.

Le barreau 2, le bras 3 et le support 4 ne forment qu'une seule et même pièce, qui a été découpée dans une plaquette de matériau piézoélectrique, par exemple du quartz, par l'un quelconque des procédés d'usinage de ces matériaux qui sont bien connus des spécialistes et qui ne seront pas décrits ici.

De manière classique pour un barreau destiné à vibrer dans un mode d'allongement, l'axe longitudinal 2a du barreau 2 est sensiblement parallèle à l'axe mécanique Y du matériau piézoélectrique dont est fait le résonateur 1.

La largeur du barreau 2, c'est-à-dire sa dimension perpendiculaire à son axe longitudinal 2a et parallèle au plan de la figure 1, peut être, selon les cas, sensiblement parallèle à l'axe optique Z ou à l'axe électrique X de ce matériau piézoélectrique.

Cette dernière orientation est généralement préférée, car c'est celle qui permet d'usiner le résonateur 1 à l'aide du procédé le mieux adapté à la fabrication en grandes séries, c'est-à-dire le procédé bien connu comportant le dépôt d'un masque par voie photolithographique sur une plaquette de matériau piézoélectrique et l'attaque chimique de cette plaquette aux endroits où elle n'est pas protégée par ce masque.

Dans tous les cas, et de manière également classique pour un barreau destiné à vibrer dans un mode d'allongement, les électrodes d'excitation de la vibration du barreau 2 sont disposées sur les faces de celui-ci qui sont sensiblement perpendiculaires à l'axe électrique X du matériau piézoélectrique.

Le résonateur 1 comporte en outre, de manière classique, des pistes conductrices disposées sur le bras 3 et sur le support 4 et reliant les électrodes d'excitation de la vibration du barreau 2 à des bornes de connexion situées dans la zone du support 4 qui est destinée à être fixée à la base B mentionnée ci-dessus.

Ces électrodes, ces pistes et ces bornes n'ont pas été représentées pour ne pas charger inutilement le dessin et parce que leur forme et leur disposition peuvent être facilement déterminées, de cas en cas, par un spécialiste en la matière.

On voit facilement que, dans le résonateur 1 selon l'invention qui vient d'être décrit, le nombre de modes parasites est nettement plus faible que dans les résonateurs connus décrits dans les brevets GB-B-1 560 537 et US-A-4 608 510 mentionnés ci-dessus, puisque les moyens de suspension de son barreau 2 ne comportent qu'un seul bras 3 et un seul support 4, alors que les moyens de suspension du barreau de ces résonateurs connus comportent deux bras et deux supports qui peuvent être, chacun, le siège de vibrations dans des modes parasites ayant des fréquences différentes.

En outre, du fait que ces moyens de suspension du barreau 2 de ce résonateur 1 selon l'invention ne sont fixés qu'à une seule des faces latérales de ce barreau 2, la largeur du support 4, c'est-à-dire sa dimension dans la direction perpendiculaire à celle de l'axe longitudinal 2a du barreau 2, peut être nettement plus importante, pour un même barreau vibrant et sans augmenter la largeur totale du résonateur, que celle de chacun des supports situés de part et d'autre du barreau vibrant dans les résonateurs connus.

Comme la rigidité du support 4, et donc les fréquences des modes parasites de vibration dont il est le siège, dépendent directement de sa largeur, ces fréquences peuvent être nettement plus élevées dans le résonateur selon l'invention que dans les résonateurs connus.

En pratique, et toujours pour une même largeur totale du résonateur, on voit qu'on peut donner au support 4 du résonateur selon l'invention une largeur aussi grande que la somme des largeurs des deux supports des résonateurs connus augmentée de la largeur de l'un des espaces qui, dans ces résonateurs connus, séparent le barreau vibrant de ces supports.

Comme dans ces résonateurs connus chacun des supports du barreau et chacun des espaces séparant ces supports de ce barreau est généralement au moins deux fois plus large que le barreau, le support 4 du résonateur de la présente invention peut donc avoir une largeur supérieure à six fois la largeur du barreau 2.

Des considérations théoriques vérifiées par des essais pratiques ont cependant montré que si le support 4 n'est que deux fois plus large que le barreau 2, la diminution du nombre de modes parasites mentionnée ci-dessus a déjà pour résultat que la variation des caractéristiques d'un exemplaire à l'autre du résonateur selon l'invention est nettement moins importante que dans le cas des résonateurs connus, ce qui augmente le rendement de fabrication de ce résonateur selon l'invention et diminue donc son prix de revient.

En outre, ces considérations et ces essais ont montré que si la largeur du support 4 est supérieure ou égale à trois fois la largeur du barreau 2, les fréquences des modes parasites de ce support 4 sont déjà suffisamment élevées pour que ces modes parasites ne risquent pas de perturber le fonctionnement du résonateur 1, et ceci dans toute la gamme de températures à laquelle celui-ci doit fonctionner.

De plus, le fait que les moyens de suspension du barreau 2 du résonateur 1 selon l'invention ne sont fixés qu'à une seule des faces latérales du barreau 2 a encore comme conséquence que l'autre des faces latérales de ce barreau 2 est libre de se déplacer si nécessaire. La vibration transversale de ce barreau 2, qui est obligatoirement couplée à sa vibration dans son mode principal d'allongement comme cela a été rappelé ci-dessus, ne peut donc pas se coupler directement à une vibration en mode parasite des moyens de suspension du barreau 2.

On voit donc que, dans le résonateur 1 selon l'invention, le nombre des modes parasites qui risquent de provoquer, à certaines températures, une dégradation des caractéristiques de ce résonateur est extrêmement réduit puisque le nombre total de ces modes parasites est plus faible que dans les résonateurs connus, et que la fréquence de la plupart de ces modes parasites peut être rendue suffisamment élevée pour qu'ils ne perturbent pas le mode principal de vibration du barreau, à quelque température que ce soit. En outre, le couplage entre ces modes parasites et le mode principal est beaucoup plus faible que dans ces résonateurs connus.

Il en découle que, par rapport à ces résonateurs connus, les caractéristiques des résonateurs selon l'invention et la variation de ces caractéristiques en fonction de la température sont nettement mieux prévisibles et plus constantes d'un exemplaire à l'autre. Ces caractéristiques et leur variation sont en outre beaucoup moins dépendantes de la forme et des dimensions des moyens de suspension du barreau vibrant, ainsi que de la manière dont ces résonateurs sont fixés sur leur base et de l'amplitude du signal d'excitation qui leur est appliqué.

Les contrôles des caractéristiques de ces résonateurs et de la variation de ces caractéristiques en fonction de la température qu'il est nécessaire de faire à la fin de leur fabrication peuvent donc être plus simples que dans le cas des résonateurs connus. En outre, le nombre de résonateurs qui doivent être éliminés suite à ces essais est plus faible, et donc le rendement de fabrication de ceux-ci est plus grand que dans le cas des résonateurs connus. De même les essais préliminaires qu'il faut faire avant de lancer la fabrication en série d'un nouveau résonateur peuvent être plus simples que dans le cas des résonateurs connus, et il est moins souvent nécessaire de modifier ce nouveau résonateur suite à ces essais préliminaires. Ces simplifications de ces essais et cette augmentation du rendement de fabrication diminuent évidemment le prix de revient de ces résonateurs selon l'invention par rapport à celui de ces résonateurs connus.

On voit également que, dans le résonateur selon l'invention, la présence du support 4 entre le bras 3 et la base B empêche tout couplage entre le mode principal de vibration du barreau 2 et les modes de vibration de cette base B.

Ce résonateur selon l'invention présente donc également les avantages énumérés ci-dessus par rapport à un résonateur qui serait réalisé de la manière suggérée par le brevet US-A-3 906 260 déjà mentionné, c'est-à-dire un résonateur dans lequel les moyens de suspension du barreau ne comporteraient aucun élément semblable au support 4, le bras 3 étant fixé directement à la base B.

Dans la forme d'exécution du résonateur selon l'invention représentée à la figure 2, le support 4, qui fait partie avec le bras 3 des moyens de suspension du barreau 2, comporte deux parties désignées respectivement par 4a et 4b.

La partie 4a est semblable au support 4 de la figure 1 et, comme ce dernier, elle est reliée par une de ses extrémités au bras 3.

L'autre extrémité de cette partie 4a est reliée à la partie 4b, qui a la forme d'un rectangle dont un des petits côtés est dans le prolongement de l'un des côtés de la partie 4a et dont les grands côtés sont perpendiculaires à l'axe longitudinal 2a du barreau 2 et s'étendent au-delà de ce dernier. Le support 4 a ainsi la forme générale d'un L.

Cette forme d'exécution présente l'avantage, par rapport à celle de la figure 1, d'offrir plus de place pour disposer les bornes de connexion du résonateur 1 sans pour autant augmenter la largeur totale du boîtier dans lequel celui-ci est monté.

Il faut noter que la ligne en traits interrompus 4c qui sépare les parties 4a et 4b dans la figure 2 n'a été tracée que pour simplifier la description, ces parties 4a et 4b ne formant évidemment qu'une seule pièce avec les autres composants du résonateur 1.

Dans la forme d'exécution du résonateur selon l'invention représentée à la figure 3, le support 4 a la forme d'un rectangle dont les longs côtés sont parallèles à l'axe longitudinal 2a du barreau 2, comme dans le cas de la figure 1. Cependant, dans le résonateur de la figure 3, le bras 3 est relié au support 4 au milieu de l'un de ses longs côtés, ce support 4 s'étendant ainsi de part et d'autre de ce bras 3.

Dans cette forme d'exécution, les bornes de connexion du résonateur 1 peuvent être disposées le long du grand côté du support 4 qui est opposé au bras 3, ce qui permet de diminuer la longueur du boîtier dans lequel ce résonateur 1 est monté.

De nombreuses autres formes d'exécution du résonateur selon l'invention peuvent être réalisées en modifiant la forme, les dimensions et/ou la disposition réciproque du bras et du support faisant partie des moyens de suspension du barreau vibrant de ce résonateur.

Ces autres formes d'exécution ne seront pas décrites ici parce que leur nombre est pratiquement illimité et que l'homme du métier n'aura aucune peine à les réaliser à partir de celles qui sont représentées par les figures 1 à 3.

Il va sans dire que toutes ces formes d'exécution du résonateur selon l'invention présentent par rapport aux résonateurs connus les mêmes avantages que le résonateur de la figure 1.

Dans les formes d'exécution du résonateur selon l'invention qui viennent d'être décrites, les deux faces latérales du barreau 2 ne sont pas identiques, puisque seule l'une d'entre elles est reliée aux moyens de suspension de ce barreau 2. Il peut en résulter la transformation du mode principal d'allongement de ce barreau 2 en un mode combiné d'allongement et de flexion dans un plan parallèle au plan des figures 1 à 3.

Si cette flexion du barreau 2 a une amplitude suffisante, elle peut être transmise au support 4 par le bras 3 et éventuellement se coupler avec l'un ou l'autre des modes parasites de vibration de ce support 4, ce couplage entraînant alors une dégradation des caractéristiques du résonateur 1.

La figure 4 représente une forme d'exécution du résonateur selon l'invention qui ne risque pas, ou qui risque moins que les formes d'exécution décrites ci-dessus, de présenter cet inconvénient.

Le résonateur de la figure 4, également désigné par 1, comporte un barreau 2, un bras 3 et un support 4 semblables aux éléments désignés par les mêmes références dans la figure 1. Il comporte en outre une saillie 5 disposée sur la face latérale du barreau 2 qui est opposée à celle à laquelle est relié le bras 3.

Cette saillie 5 est située au milieu de la longueur du barreau 2, c'est-à-dire en regard du bras 3. Elle est évidemment réalisée en même temps que les autres éléments du résonateur 1 et son épaisseur est donc égale à celle de ces derniers avec lesquels elle ne forme qu'une seule pièce.

Dans l'exemple représenté à la figure 4, la saillie 5 a la forme d'un rectangle dont les grands côtés sont parallèles à l'axe longitudinal 2a du barreau 2 et ont une longueur égale à la largeur du bras 3, et dont les petits côtés, perpendiculaires à cet axe, ont une longueur égale à environ la moitié de la largeur du barreau 2.

Des considérations théoriques confirmées par des essais pratiques ont cependant montré que les dimensions de cette saillie 5 ne sont pas très critiques, et que leurs rapports avec la largeur du bras 3 et, respectivement, la largeur du barreau 2 peuvent être nettement différents de ceux qui ont été mentionnés ci-dessus.

En effet, ces considérations et ces essais ont montré que la simple présence d'une saillie telle que la saillie 5 au milieu de la longueur du barreau 2 empêche l'apparition du mode de vibration parasite en flexion de de dernier, mentionné ci-dessus, ou au moins diminue fortement l'amplitude de cette vibration, grâce au fait que cette saillie rétablit une certaine symétrie entre les deux faces latérales de ce barreau 2.

Il en est d'ailleurs de même si cette saillie a une forme différente de celle de la saillie 5, c'est-à-dire si elle est, par exemple triangulaire, trapézoïdale ou semi-circulaire.

Il est en outre évident qu'une telle saillie peut être prévue, avec les mêmes avantages, dans les formes d'exécution du résonateur selon l'invention décrites à l'aide des figures 2 et 3, ou dans n'importe laquelle des autres formes d'exécution de ce résonateur mentionnées ci-dessus.

## Revendications

1. Résonateur (1) comportant un barreau parallélépipédique (2) en un matériau piézoélectrique destiné à vibrer dans un mode d'allongement et des moyens de suspension (3, 4) dudit barreau (2) formant une seule et même pièce avec ledit barreau (2) et destinés à relier ledit barreau (2) à une base (B), caractérisé par le fait que lesdits moyens de suspension (3, 4) comportent un unique bras (3) ayant une première extrémité reliée à l'une des faces latérales dudit barreau (2) sensiblement au milieu de la longueur dudit barreau (2) et un unique support (4) relié à la deuxième extrémité dudit bras (3) et destiné à être fixé à ladite base (B).

2. Résonateur selon la revendication 1, caractérisé par le fait qu'il comporte en outre une saillie (5) formant également une seule et même pièce avec ledit barreau (2) et disposée sur l'autre desdites faces latérales dudit barreau (2) sensiblement au milieu de la longueur dudit barreau (2).

3. Résonateur selon la revendication 1, caractérisé par le fait que ledit support (4) a sensiblement la forme d'un rectangle ayant deux côtés parallèles à l'axe longitudinal dudit barreau (2).

4. Résonateur selon la revendication 3, caractérisé par le fait que ledit bras (3) est relié audit support (4) à une extrémité de l'un desdits côtés parallèles à l'axe longitudinal dudit barreau (2).

5. Résonateur selon la revendication 3, caractérisé par le fait que ledit bras (3) est relié audit support (4) sensiblement au milieu de l'un desdits côtés parallèles à l'axe longitudinal dudit barreau (2).

6. Résonateur selon la revendication 1, caractérisé par le fait que ledit support (4) comporte une première (4a) et une deuxième partie (4b) ayant toutes deux la forme générale d'un rectangle ayant deux côtés parallèles à l'axe longitudinal dudit barreau (2), ladite deuxième partie (4b) étant reliée à l'une des extrémités de ladite première partie (4a) de manière que ledit support (4) a la forme générale d'un L, et ledit bras (3) étant relié à l'autre extrémité de ladite première partie (4a).

7. Résonateur selon la revendication 3, caractérisé par le fait que la largeur dudit support (4) est égale ou supérieure à deux fois la largeur dudit barreau (2).

8. Résonateur selon la revendication 7, caractérisé par le fait que la largeur dudit support (4) est égale ou supérieure à trois fois ladite largeur dudit barreau (2).

## Patentansprüche

1. Resonator (1), umfaßend einen parallelepipedischen Stab (2) aus einem piezoelektrischen Material, der dazu bestimmt ist, in einem Verlängerungsmodus zu vibrieren und Einspannmittel (3, 4) dieses Stabs (2), welche ein einziges Bauteil mit dem Stab (2) bilden und dazu bestimmt sind, den Stab (2) mit einer Basis (B) zu verbinden, dadurch gekennzeichnet, daß die Einspannmittel (3, 4) einen einzigen Arm (3) umfassen, der mit einem ersten Ende an einer der Seiten des Stabs (2) im wesentlichen in der Mitte der Länge dieses Stabs (2) verbunden ist und einen einzigen Support (4) umfassen, der mit dem zweiten Ende des Arms (3) verbunden ist und dazu bestimmt ist, an der Basis (B) befestigt zu werden.

2. Resonator nach Anspruch 1, dadurch gekennzeichnet, daß er ferner einen Vorsprung (5) umfaßt, der ebenfalls einstückig mit dem Stab (2) ausgebildet ist und auf der anderen der genannten Seiten des Stabs (2) im wesentlichen in der Mitte der Länge des Stabs (2) angeordnet ist.

3. Resonator nach Anspruch 1, dadurch gekennzeichnet, daß der Support (4) im wesentlichen die Form eines Rechtecks mit zwei zur Längsachse des Stabs (2) parallelen Seiten aufweist.

4. Resonator nach Anspruch 3, dadurch gekennzeichnet, daß der Arm (3) mit dem Support (4) an einem Ende einer der zur Längsachse des Stabs (2) parallelen Seiten verbunden ist.

5. Resonator nach Anspruch 3, dadurch gekennzeichnet, daß der Arm (3) mit dem Support (4) im wesentlichen in der Mitte einer der zur Längsachse des Stabs (2) parallelen Seiten verbunden ist.

6. Resonator nach Anspruch 1, dadurch gekennzeichnet, daß der Support (4) eine erste (4a) und eine zweite (4b) Partie umfaßt, welche beide die allgemeine Form eines Rechtecks aufweisen mit zwei Seiten parallel zur Längsachse des Stabs (2), wobei die zweite Partie (4b) mit einem der Enden der ersten Partie (4a) derart verbunden ist, daß der Support (4) generell die Form eines L aufweist und daß der Arm (3) mit dem anderen Ende der ersten Partie (4a) verbunden ist.

7. Resonator nach Anspruch 3, dadurch gekennzeichnet, daß die Breite des Supports (4) gleich oder größer dem Zweifachen der Breite des Stabs (2) ist.

8. Resonator nach Anspruch 7, dadurch gekennzeichnet, daß die Breite des Supports (4) gleich oder größer dem Dreifachen der Breite des Stabs (2) ist.

## Claims

1. Resonator (1) comprising a parallelepipedic bar (2) of a piezoelectric material designed to vibrate in an extension mode and suspension means (3, 4) of said bar (2) forming a single part integral with said bar (2) and designed to connect said bar (2) to a base (B), characterized by the fact that said suspension means (3, 4) comprises a single arm (3) having a first extremity connected to one of the lateral faces of said bar (2) substantially at the middle of the length of said bar (2) and a single support (4) connected to the second extremity of said arm (3) and designed to be fixed to said base (B).

2. Resonator according to claim 1, characterized by the fact that it further comprises a protrusion (5) also forming a single part integral with said bar (2) and disposed on the other of said lateral faces of said bar (2) substantially at the middle of the length of said bar (2).

3. Resonator according to claim 1, characterized by the fact that said support (4) has substantially the shape of a rectangle having two sides parallel to the longitudinal axis of said bar (2).

4. Resonator according to claim 3, characterized by the fact that said arm (3) is connected to said support (4) at one extremity of one of said sides parallel to the longitudinal axis of said bar (2).

5. Resonator according to claim 3, characterized by the fact that said arm (3) is connected to said support (4) substantially at the middle of one of said sides parallel to the longitudinal axis of said bar (2).

6. Resonator according to claim 1, characterized by the fact that said support (4) comprises a first (4a) and a second part (4b), both having substantially the shape of a rectangle having two sides parallel to the longitudinal axis of said bar (2), said second part (4b) being connected to one of the extremities of said first part (4a) in such a way that said support (4) has the general shape of a L, and said arm (3) being connected to the other extremity of said first part (4a).

7. Resonator according to claim 3, characterized by the fact that the width of said support (4) is equal to or greater than twice the width of said bar (2).

8. Resonator according to claim 7, characterized by the fact that the width of said support (4) is equal to or greater than three times said width of said bar (2).
